Europäisches Patentamt

European Patent Office

Office européen des brevets

(19)

(11) Veröffentlichungsnummer: **0 152 577
B1**

(12) **EUROPÄISCHE PATENTSCHRIFT**

(45) Veröffentlichungstag der Patentschrift: **27.06.90**

(21) Anmeldenummer: **84115047.7**

(22) Anmeldetag: **10.12.84**

(51) Int. Cl.⁵: **C 23 C 14/54,** G 01 R 27/00,
G 05 D 5/03, H 01 C 17/08

(54) **Verfahren zur Kontrolle und Regelung der Legierungszusammensetzung von elektrisch leitenden metallischen Schichten während ihrer Herstellung.**

(30) Priorität: **16.02.84 DE 3405596**

(43) Veröffentlichungstag der Anmeldung:
**28.08.85 Patentblatt 85/35**

(45) Bekanntmachung des Hinweises auf die
Patenterteilung:
**27.06.90 Patentblatt 90/26**

(84) Benannte Vertragsstaaten:
**AT CH DE FR GB IT LI**

(56) Entgegenhaltungen:
EP-A-0 033 507
GB-A-1 446 849
US-A-3 775 278

PATENT ABSTRACTS OF JAPAN, Band 8, Nr. 52
(C-213)1489r, 9. März 1984; & JP-A-58 207 369
(MATSUSHITA DENSHI KOGYO K.K.) 02-12-1983

PATENT ABSTRACTS OF JAPAN, Band 3, Nr. 32,
17. März 1979, Seite 81 C40; & JP-A-54 6879
(MATSUSHITA DENKI SANGYO K.K.) 19-01-1979

PATENT ABSTRACTS OF JAPAN, Band 2, Nr.
131, 31. Oktober 1978, Seite 2719 C 78; &
JP-A-53 95 884 (MATSUSHITA DENKI SANGYO
K.K.) 22-08-1978

(73) Patentinhaber: **Siemens Aktiengesellschaft
Wittelsbacherplatz 2
D-8000 München 2 (DE)**

(72) Erfinder: **Hieber, Konrad, Dr. rer. nat.
Laubensteinstrasse 7
D-8214 Bernau (DE)**
Erfinder: **Mayer, Norbert, Dr. rer. nat.
Werdenfelsstrasse 77
D-8000 München 70 (DE)**

(56) References cited:
**THIN SOLID FILMS, Band 96, Nr. 2, Oktober
1982, Seiten 121-127, Elsevier Sequoia,
Lausanne, CH; M.I. RIDGE et al.: "Composition
control in conducting oxide thin films"**

**THIN SOLID FILMS, Band 80, 1981, Seiten 31-39,
Elsevier Sequoia, Lausanne, CH; M.I. RIDGE et
al.: "The application of ion plating to the
continuous coating of flexible plastic sheet"**

**IEEE TRANSACTIONS ON MAGNETICS, Band
MAG-11, Nr. 2, März 1975, Seiten 201-207, New
York, US; R.H. HAMMOND: "Electron beam
evaporation synthesis of A15 superconducting
compounds: accomplishments and prospects"**

# EP 0 152 577 B1

**Beschreibung**

Die Erfindung betrifft ein Verfahren zur Kontrolle und Regelung der Legierungszusammensetzung von elektrisch leitenden metallischen Schichten, wie sie insbesondere in der Halbleiter- und Dünnschichttechnik verwendet werden, während der Schichtherstellung durch Aufdampfen oder Aufstäuben mit Hilfe von elektrischen Widerstandsmessungen.

Die genaue Kenntnis der Zusammensetzung von Schichten, die durch Aufdampfen oder Aufstäuben (Sputtern) hergestellt werden, ist für die Fertigung von Dünnschichtschaltungen bzw. integrierten Halbleiterschaltungen von großer Bedeutung.

Die Zusammensetzung beeinflußt sehr empfindlich die elektrischen und metallkundlichen Eigenschaften (zum Beispiel Diffusion, Reaktion) von dünnen Schichten.

Im Zuge der fortschreitenden Miniaturisierung sind die Toleranzen bezüglich Zusammensetzung und Schichtdicke sehr eng geworden, so daß eine Messung und Steuerung dieser beiden Größen bereits bei der Schichterstellung unerläßlich ist, um eine genügend hohe Ausbeute zu erreichen.

Bei Chrom-Nickel-Dünnschicht-Widerständen wird der Temperaturkoeffizient des elektrischen Widerstandes, der zum Beispiel im Bereich von $-25$ bis $+25 \times 10^{-6}$ K$^{-1}$ liegen muß, sehr empfindlich von der Zusammensetzung beeinflußt.

Um diese Werte reproduzierbar einhalten zu können, darf die Konzentration nur um $\pm 3\%$ Atomzahlanteil schwanken.

Auch bei Tantalsilizid-Schichten, die in der VLSI-Technologie unter anderem als niederohmiges Gatematerial bzw. als Leiterbahnen eingesetzt werden, wird der spezifische elektrische Widerstand stark von der Zusammensetzung beeinflußt. Ferner besitzen nur Schichten mit einer bestimmten Konzentration die Eigenschaft, in einer oxidierenden Atmosphäre bei Temperaturen um 900°C eine $SiO_2$-Schutzschicht zu bilden. Auch in diesem Fall erhält man nur dann ein reproduzierbares Oxidwachstum, wenn die Zusammensetzung nur geringfügig ($\pm 2\%$ Atomzahlanteil) um einen festen Wert schwankt.

Um bezüglich der Zusammensetzung homogene Schichten zu erhalten, ist es bekannt, die Substrate während der Beschichtung zu bewegen (zum Beispiel Rotation, Planetenbewegung). Da ferner moderne Beschichtungsanlagen sehr oft eine Schleuse besitzen, über die die Substrate in die eigentliche Beschichtungskammer eingeführt werden, ist das Substrat nicht ortsfest, wodurch eine in situ-Bestimmung der Zusammensetzung sehr erschwert wird.

Eine Möglichkeit, die Konzentration während der Schichtherstellung zu überwachen, besteht darin, mehrere ortsfeste Quarzoszillatoren, deren Resonanzfrequenz sich mit zunehmender Massenbelegung durch ein aufgedampftes oder aufgestäubtes Material definiert ändert, in der Anlage zu installieren. Will man die Zusammensetzung zum Beispiel einer binären Legierungsschicht mit Hilfe von Quarzoszillatoren kontrollieren oder regeln, so muß gewährleistet sein, daß mindestens zwei Schwingquarze in der Anlage montiert sind, wobei jeder Oszillator nur von einer Quelle beschichtet wird. Aus dem Verhältnis der momentanen Massenbelegung kann auf die Zusammensetzung der Schicht geschlossen werden.

Eine weitere, sehr genaue Möglichkeit, die Schichtzusammensetzung zu regeln, besteht darin ein Massenspektrometer einzusetzen, bei dem von beiden Verdampfern stammende Material in die Ionenquelle gelangt und registriert wird. Auch hier besteht der Nachteil, daß die Ionenquelle ortsfest ist. Ferner ist diese Methode in Sputteranlagen während der Beschichtung nicht anwendbar bzw. zu ungenau, da die Abscheidung bei einem Argon-Druck von ca. $10^{-2}$ mbar erfolgt.

Bei den gennanten beiden Verfahren wird stets das Konzentrationsverhältnis entsprechend dem Verhältnis der Raten der Beschichtungsquellen überwacht, jedoch nicht das Konzentrationsverhältnis, das sich in Wirklichkeit in der Schicht ausbildet. Deshalb können bei Anwendung dieser Verfahren zur Regelung der Schichtkonzentration je nach Toleranzgrenzen Ausschußraten von bis zu 50% auftreten. Dadurch entstehen hohe Kosten, da die Substrate, bevor sie mit Metallschichten bedampft werden, oft schon viele Prozeßschritte durchlaufen haben.

In der DE—OS 30 04 149 ist ein Verfahren beschrieben, mit dem metallische Schichten reproduzierbar herstellbar sind. Dabei wird zur dynamischen Steuerung des Beschichtungsprozesses fortlaufend eine Reihe von Istwerten ($p\infty$, $I\infty$, $p$, $h$) ermittelt und errechnet und mit Sollwerten verglichen. Bei Abweichungen der Ist- von den Sollwerten werden die Beschichtungsparameter wie Substrattemperatur, Beschichtungsrate, Dotiergasdruck und Schichtszusammensetzung geeignet verändert. Dieses in der DE—OS 30 04 149 beschriebene Verfahren hat einen wesentlichen Nachteil:

Zur Errechnung der 4 Istwerte muß eine relativ komplizierte Formel auf iterativem Wege gelöst werden, was einigen Rechenaufwand innerhalb kürzester Zeit zur Folge hat und teuere Rechenanlagen erfordert. Außerdem sind vier Regelgrößen und vier Stellglieder beschrieben.

Aufgabe der Erfindung ist es, für die Herstellung von Legierungsschichten, wobei die Legierungskomponenten oder Vorlegierungen kontinuierlich und/oder alternierend (zeitlich nacheinander), das heißt lagenweise auf das Substrat aufgebracht werden, ein Verfahren anzugeben, das es erlaubt, Änderungen in der Legierungszusammensetzung noch während des Schichtherstellungsprozesses zu erfassen, und gemäß den festgestellten Änderungen die Raten der einzelnen Materialquellen, das heißt das Ratenverhältnis so zu verändern, daß wieder die gewünschte Legierungszusammensetzung erreicht wird. Eine weitere Aufgabe ist es, dieses Verfahren auf die Herstellung von Schichten, deren Konzentration sich mit der Schichtdicke kontinuierlich oder diskontinuierlich ändert, anzuwenden. Das Verfahren soll

2

einfach sein und keine größeren iterativen Berechnungen zur Ermittlung der Regelgrößen erfordern.

Zur Lösung der erfindungsgemäßen Aufgabe wird ein Verfahren der eingangs genannten Art vorgeschlagen, das dadurch gekennzeichnet ist, daß

a) fortlaufend der momentane elektrische Schichtwiederstand $R_i$ und die momentane Schichtdicke $d_i$ gemessen bzw. bestimmt werden,

b) daraus der Istwert der Regelgröße $\rho\infty_i$ ermittelt wird,

c) der Istwert mit dem Sollwert von $\rho\infty_i$ für die Schichtdicke $d_i$ verglichen wird,

d) bei Regelabweichungen (Soll-Istwert-Differenzen) das Ratenverhaltnis der Beschichtungsquellen (A und B) als Stellgröße entsprechend verändert wird und

e) bei Erreichen eines bestimmten Endwertes der Beschichtungsvorgang beendet wird.

Wenn der Endwert der Schichtdicke $d_n$ oder der Endschichtwiderstand erreicht ist, wird der gesamte Beschichtungsvorgang beendet.

Die Istwerte der Regelgröße $\rho\infty_i$ ergeben sich aus mindestens zwei Produkten $(\rho \cdot d)_i$ und $(\rho \cdot d)_{i-j}$ $(1 \leq j < i)$, mit $(\rho \cdot d)_i = \rho_i \cdot d_i$.

Die Sollwerte von $\rho\infty_i$ können entweder über den gesamten Schichtdickenbereich konstant sein, wie es inbesondere für die Herstellung von metallisch leitenden Schichten zum Beispiel Widerstandsschichten, Leiterbahnen oder Gateelektroden der Fall ist, oder sie ändern sich mit der Schichtdicke, kontinuierlich oder diskontinuierlich, wie es insbesondere für die Erzeugung von Konzentrationsgradienten oder Diffusionbarrieren in der Schicht nötig ist, das heißt, die Legierungszusammensetzung ändert sich dann kontinuierlich oder diskontinuierlich mit der Schichtdicke.

Wenn die Schichtzusammensetzung nur kontrolliert werden soll, werden lediglich die oben beschreibenen Istwerte der Regelgröße während der Schichtherstellung erfaßt. Eine Regelung findet dann nicht statt. Nach der Schichtherstellung ist dann bereits ohne weitere Untersuchungen der Schicht bekannt, ob die hergestellte Schicht insbesondere die gewünschten elektrischn Eigenschaften besitzt. Dieses im Vergleich zur Regelung eingeschränkte Verfahren der Kontrolle ist für eine Fertigung bereits von großer Bedeutung, da bei der Herstellung eines Halbleiterbauelements eine Vielzahl von Folgeschritten unterbleiben kann, wenn man bereits nach der Beschichtung weiß, daß die aufgebrechts metallische Schicht nicht "gut" ist.

Als Schichtherstellungsprozesse werden bevorzugt das Aufdampfen im Vakuum (Druck $<10^{-5}$ mbar) und das Sputtern verwendet, wobei zwei örtlich getrennte Materialquellen vorhanden sein müssen.

Beim Aufbringen der Schichten kann das Material kontinuierlich oder mit zeitlichen Unterbrechungen, das heißt diskontinuierlich, aufgebracht werden. Beim diskontinuierlichen Aufbringen der Schichten werden üblicherweise die zu beschichtenden Substrate unter der Materialquelle, die mit einer konstanten Beschichtungsrate arbeitet, zyklisch hindurchbewegt, so daß die Schichten lagenweise aufgebracht werden. Hinweise dafür sind zu entnehmen aus einem Aufsatz von K. Hieber, Siemens Forsch.- u. Entwickl.-Ber. 11 (1982), Seiten 145 bis 148. Mit jeder aufgebrachten Schichtlage erniedrigt sich der Schichtwiderstand stufenartig (vergleiche dazu N. M. Mayer, Siemens Forsch.- u. Entwickl.-Ber. 11 (1982) Seiten 322 bis 326). Speziell beim gleichzeitigen Sputtern von mehreren Targets ("Co-Sputtern") wird diese Methode des lagenweisen Aufbringens von Teilschichten angewandt.

Beim erfindungsgemäßen Verfahren werden die einzelnen Legierungskomponenten oder -partner (Vorlegierungen) von zwei getrennten Quellen (zum Beispiel Verdampferquellen oder Targets) aufgebracht, die entweder die reinen Elemente zum Beispiel Cr oder Ni für Cr-Ni-Schichten oder auch Vorlegierungen zum Beispiel Al/Si und Ti für Al/Si/Ti-Leiterbahnen oder Ta/Si oder Ta für $TaSi_2$-Gatematerial oder Leiterbahnen enthalten können.

Die Schichtdicke kann einerseits gemessen werden, oder aus der Beschichtungszeit und den Beschichtungsraten berechnet werden.

Gegenstand der vorliegenden Erfindung ist es also, den Prozeß der Herstellung von elektrisch leitenden Schichten dynamisch zu regeln, das heißt, daß noch während der Herstellung der Schicht—wenn nötig—die momentan aufzubringende Legierungszusammensetzung verändert wird.

Folgende Überlegungen haben zu der Lehre der Erfindung geführt:

Die Erfindung geht von der Erkenntnis aus, daß die Größe $\rho\infty$ als Regelgröße geeignet ist, die Legierungszusammensetzung die gerade auf die Schicht aufgebracht wird, aufzuzeigen. Voraussetzung ist hierbei, daß die Materialien der beiden Quellen unterschiedliche spezifische elektrische Widerstände haben. Mißt man während der Schichtherstellung den spezifischen elektrischen Widerstand $\rho$ in Abhängigkeit von der Schichtdicke d und trägt das Produkt aus $\rho \cdot d$ gegen d graphisch auf, so erhält man im Idealfall für $d > l\infty$ ($l\infty$ = mittlere freie Weglänge der Elektronen) einen linearen Zusammenhang gemäß der Formel von Sondheimer (siehe dazu H. Hoffmann, J. Vancea, Thin Solid Films, 85 (1981), Seiten 147 bis 167).

$$(1) \qquad \rho \cdot d = \rho\infty \cdot d + 3/8 \, \rho\infty \, l\infty \, (1-P)$$

mit P als sogenannten Spiegelungsparameter und $\rho\infty$ als den spezifischen elektrischen Widerstand der Schicht bei "unendlicher" Schichtdicke, das heißt, bei sehr dicken Schichten, so daß keine Dünnschichteffekte die elektrische Leitfähigkeit der Schicht beeinflussen.

Aus (1) ergibt sich als 1. Ableitung nach d (Differentation nach d)

$$(2) \qquad \frac{\Delta(\rho \cdot d)}{\Delta d} = \rho \infty$$

das heißt, die Steigung der Geraden in der $\rho \cdot d$ gegen d Darstellung entspricht $\rho \infty$.

Das besondere an der Größe $\rho \infty$ ist, daß diese Größe zu jedem Zeitpunkt während der Schichtherstellung angibt, welchen spezifischen elektrischen Widerstand das Material momentan hat, das auf die entstehende Schicht aufgebracht wird, während der direkt gemessene oder ermittelte spezifische elektrische Widerstand $\rho$ (aus $R = \rho \cdot l/dq$ mit R als gemessenem Widerstand, l als Länge und q als Breite der Meßstrecke) immer nur integral den spezifischen elektrischen Widerstand der Schicht angibt.

Werden zwei Materialien gemischt, so steht ihr spezifischer elektrischer Widerstand in enger Korrelation mit der Legierungszusammensetzung (siehe Aufsatz von Politycki und Hieber, Siemens Forsch.- u. Entwickl. Ber. 3 (1974), Seite 248), das heißt, wenn sich die Legierungszusammensetzung ändert, so ändert sich auch der spezifische elektrische Widerstand und somit $\delta \infty_l$.

Sollte in einem bestimmten Leigerungsbereich der spezifische elektrische Widerstand unabhängig von der Konzentration sein, so ist das geschilderte Verfahren nicht verwendbar.

Während der Schichtherstellung muß demnach der elektrische Schichtwiderstand fortlaufende gemessen werden; bevorzugt ist die Messung an einem Referenzsubstrat, auf dem die Schicht mit einer definierten Geometrie hergestellt wird. Der spezifische elektrische Widerstand ergibt sich dann nach der bekannten Formel $\rho = R \cdot d \cdot q/l$. Die Widerstandsmessung erfolgt bevorzugt durch eine 2 oder 4-Punkt Widerstandsmeßmethode mit Gleich- oder Wechselstrom. Zur Messung des elektrischen Widerstandes in Anlagen mit Vakuumschleuse und bewegten Substratenwird bevorzugt eine Widerstandsmeß- und -übertragungsapparatur verwendet wie sie in Siemens Forsch.- u. Entwickl.-Ber. 11 (1982), Seiten 322 bis 326, beschrieben ist.

Als Regelgröße können auch der gemessene elektrische Schichtwiderstand R oder die hiermit direkt zusammenhängenden Größen, wie spezifischer elektrischer Widerstand $\rho$ oder Flächenwiderstand $R_F$ verwendet werden. Da es sich—wie oben bereits festgestellt, hierbei um integrale Größen handelt, die auch noch durch Schichtdickeneffekte beeinflußt werden können, ist die theoretische Festlegung der Sollwerte dieser Regelgrößen sehr schwierig; die Sollwerte können jedoch experimentell bestimmt werden.

Die Verwendung von R, $\rho$ oder $R_F$ als Regelgrößen ist deshalb nur sinnvoll bei größeren Schichtdicken und konstanter Legierungszusammensetzung über den Schichtquerschnitt.

Die Schichtdicke kann mit den üblichen bekannten Verfahren gemessen werden zum Beispiel Schwingquarz, optische Interferenzmethoden. Es ist auch möglich, die momentane Schichtdicke aus den Beschichtungsraten und der Beschichtungszeit zu errechnen. Wenn die Beschichtungszeiten während der Schichtherstellung geändert werden, was im Falle einer Regelung der Fall ist, ist es nötig, die Schichtdicken aufzusummieren, die sich für die einzelnen Zeitabschnitte mit jeweils konstanter Beschichtungsrate ergeben. Der Fehler, der bei der Schichtdickenbestimmung gemacht wird, ist zu vernachlässigen, wenn die Regelabweichung zwischen zwei Messungen des elektrischen Widerstandes nicht zu groß ist, entsprechend einer Konzentrationsabweichung von $\pm 10\%$. Bei einer reinen Kontrolle des Schichtherstellungsprozesses dagegen kann die Ermittlung der Schichtdicke aus Rate und Zeit bevorzugt verwendet werden, enn hierbei soll gerade kontrolliert werden, ob die Schichten untereinander vergleichbar sind.

Bei der diskontinuierlichen (lagenweisen) Schichtherstellung läßt sich die momentane Schichtdicke auch aus der Anzahl der aufgebrachten Teillagen und der Dicke einer Teillage errechnen. Bei Ratenänderungen werden die Dicken der einzelnen Teillagen aufsummiert, analog zu den obigen Feststellungen.

Die Beschichtungsraten oder die Dicke einer Teillage in Abhängigkeit von der Energieversorgung für die Materialquellen (zum Beispiel beim Target die Targetspannung oder bei einem widerstandsbeheizten Verdampfer der elektrische Strom) werden in Vorversuchen festgelegt.

Somit wird während der Schichtherstellung fortlaufend ein Wertepaar $R_i$, $d_i$ gemessen oder speziell $d_i$ ermittelt und daraus $\rho_i$ und $(\rho \cdot d)_i$ errechnet:

|  | erster Wert | Endwert |
|---|---|---|
| Widerstand (gemessen) | $R_1...R_j...R_i...R_{n-1}$ | $R_n$     $0<j<i$ |
| Schichtdicke (gemessen oder errechnet) | $d_1...d_j...d_i...d_{n-1}$ | $d_n$ |
| spez. elektr. Widerstand | $\rho_1...\rho_j...\rho_i...\rho_{n-1}$ | $\rho_n$ |
| Produkt | $(\rho \cdot d)_1...(\rho \cdot d)_j...(\rho \cdot d)_i...$ $(\rho \cdot d)_{n-1}$ | $(\rho d)_n$ |
| Istwert der Regelgröße | $—\rho\infty_j...\rho\infty_i...\rho\infty_{n-1}$ | $\rho\infty_n$ |

a) Der Istwert der Regelgröße $\rho\infty_i$ ergibt sich aus den Wertepaaren von $(\rho \cdot d)_i$ und $d_i$ nach den üblichen Formeln zur Berechnung von Steigungen von Geraden unter Zugrundelegung von einem oder mehreren Wertepaaren für $j<i$, die zuletzt bestimmte wurden, und dem aktuellen Wertepaar i.

Speziell für 2 Wertepaare gilt:

$$(3) \qquad \rho\infty_i = \frac{(\rho d)_i - (\rho d)_j}{d_i - d_j} \qquad \begin{array}{l} (i>1) \\[4pt] \text{speziell: } j = i-1 \end{array}$$

Bei Verwendung von 3 oder mehr Wertepaaren zur Berechnung von $\rho\infty_i$ können entsprechende Formeln verwendet werden, wie sie in den mathematischen Formelsammlungen für Ausgleichsgeraden durch mehrere Punkte angegeben werden.

Bei der kontinuierlichen Schichtherstellung ergibt sich der zeitliche Abstand zwischen zwei Bestimmungen des Istwertes der Regelgröße aus der Beschichtungsrate. Bevorzugt ist eine neue Bestimmung des Istwertes der Regelgröße nach dem Aufbringen von jeweils einer Schichtdicke $\Delta d$ von 0.5 bis 0.5 nm, besonders bevorzugt von 1 bis 20 nm, das heißt, bei einer Beschichtungsrate von zum Beispiel 10 nm/sec ist es besonders günstig, alle 0,2 bis 2 sec einen neuen Istwert der Regelgröße zu bestimmen. Erfolgt die Schichtherstellung dagegen diskontinierlich, das heißt lageweise, ist es günstig, den Istwert der Regelgröße jeweils nach einem Durchgang des Substrats, an dem gemessen wird, unter allen Beschichtungsquellen (zum Beispiel zwei beim Cosputtern) zu bestimmen. Bei Verwendung einer Drehpalette erfolgt dann die Istwertbestimmung nach jeweils einer Palettenumdrehung.

b) Werden als Regelgröße— wie oben beschrieben R, $\rho$, $R_F$ oder ähnliche direkt aus den Meßwerten errechenbaren Größen verwendet, so sollen in diesem Fall diese Größen gleich der Regelgröße $\rho\infty_i$ gesetzt werden.

Die Sollwerte der Regelgröße liegen vor der Schichtherstellung fest. Im Fall von Schichten mit konstanter Legierungszusammensetzung über den gesamten Schichtquerschnitt, wie es insbesondere bei Widerstandsschichten, Leiterbahnen oder Gateelektroden der Fall ist, ist der Sollwert eine konstante Größe, die dem gewünschten spezifischen elektrischen Widerstand der Schicht entspricht. Der Sollwert von $\rho\infty=\rho\infty_j=\rho\infty_i$ ist somit unabhängig von der Schichtdicke.

Im anderen Fall hängt der Sollwert der Regelgröße von der Schichtdicke ab, das heißt, jedem Schichtdickenwert $d_i$ entspricht ein eingener Sollwert von $\rho\infty_i$. Diese Sollwerte können entweder theoretisch oder experimentell festgelegt werden, das heißt, im letzteren Fall wird zunächst ein Schicht hergestellt, wobei zum Beispiel von Hand die Rate für die Materialquellen verändert wird und die Istwerte von $\rho\infty_i$ bestimmt und aufgezeichnet (gespeichert) werden, und wenn sich die so hergestellte Schicht in nachfolgenden Testuntersuchungen als geeignet herausgestellt hat, können diese Istwerte von $\rho\infty_i$ bei der späteren fertigungsmäßigen Schichtherstellung als Sollwerte verwendet werden.

Die gemessenen Istwerte der Regelgröße $\rho\infty_i$ werden während der Schichtherstellung fortlaufend mit den Sollwerten verglichen, das heißt mit dem für die entsprechende aktuelle Schichtdicke aktuellen Sollwert. Bei Soll-Istwert-Differenzen, das heißt Regelabweichungen, wird über entsprechende Stellglieder die Beschichtungsrate von einem oder beiden Beschichtungsquellen entsprechend geändert. Dies geschieht im einfachsten Fall über die Energieversorgung der Quellen. Hat jede Quelle eine eigene Energieversorgung, so wird nur eine oder beide Energieversorgungen geändert. Haben die Quellen nur eine gemeinsame Energieversorgung und wird das Ratenverhältnis über einen sogenannten "Powersplitter" (zum Beispiel Widerstand, Kapazität, Induktivität) eingestellt, so wird diese "Leistungsaufteilung" geändert. Diese geänderte(n) Rate(n) kann (können) dann der Schichtdickenbestimmung zugrundegelegt werden Durch dieses Verstellen der Stellgröße (Verhältnis der Beschichtungsraten) bei Soll-Istwert-Differenzen kann die Regelgröße an die Führungsgröße (=Sollwert der Regelgröße) angeglichen werden.

Die Richtung der Herstellung des Ratenverhältnisses (Stellgröße) der beiden Beschichtungsquellen A und B ist eindeutig: Ergibt sich ein zu hoher Istwert von $p\infty_i$ so ist der Anteil des höherohmigen Materials A zu hoch und es muß das Ratenverhältnis A/B in der Weise geändert werden, daß der Anteil (Rate) des höherohmigen Materials A verringert wird bei konstanter Rate der zweiten Materialquelle B (niederohmigeres Material), oder Rate A wird verringert und Rate B erhöht, oder Rate A bleibt konstant und nur Rate B wird erhöht. Bei zu niedrigem Istwert von $p\infty_i$ erfolgt eine analoge Änderung des Ratenverhältnisses. Um wieviel das Ratenverhältnis bei Regelabweichungen verändert werden muß, wird durch geeignete Vorversuche ermittelt, zum Beispiel Abhängigkeit von $p\infty$ von der Schichtkonzentration (=Ratenverhältnis=Einstellung (en) der Energieversorgung(en) der Materialquellen). Die geänderte(n) Rate(n) werden—wenn benötigt—der Schichtdickenberechnung zugrundegelegt.

Im einfachsten Fall erfolgt die stetige Regelung bevorzugt in der bekannten Art der P-Regler (Proportional-Regler). Eine stetige Regelung nach der bekannten Art der Integral-, Proportional-Integral-, Proportional-Differential- oder Proportional-Integral-Differential-Regler ist ebenfalls möglich.

Bezüglich dieser Antwortfunktionen (zeitabhängiger Zusammenhang) zwischen der Änderung der Ein- und Ausgangsgrößen) wird auf den Stand der Technik verwiesen, wie er insbesondere aus Dubbel, Taschenbuch für den Maschinenbau, 14. Auflage 1981, Seiten 1267 bis 1282 und 1446 bis 1448 und der dort genannten Literatur hervorgeht.

Die Ermittlung (Berechnung) der Istwerte von $p\infty_i$, der Vergleich mit den Sollwerten und die Steuerung der Beschichtungsrate über die Energieversorgung der Materialquellen wird bevorzugt durch einen Prozeßrechner (Kleincomputer) durchgeführt. Die Energieversorgung kann von einem Rechner leicht über einen Digital/Analog-Wandler gesteuert werden.

Im Falle einer konstanten Führungsgröße ($p\infty_i$=konstant) sind auch hardware-mäßige Schaltungsausführungen möglich, bestehend aus einem analogen Multiplikator zur Berechnung der Istwerte, einem Komparator zur Bestimmung der Regelabweichung und einem Spannungsgeber zur Steuerung der Raten der Materialquellen.

Der Beschichtungsprozeß wird beendet, wenn ein vorher festgelegter Endwert erreicht wird; es können hierzu eine Reihe von Werten verwendet werden:

Zum Beispiel Schichtwiderstand, Flächenwiderstand, spezifischer elektrischer Widershand, Schichtdicke, Beschichtungszeit. Das Beenden des Beschichtungsprozesses kann insbesondere durch Abschalten der Materialquelle(n) oder durch Blende(n) zwischen Materialquelle(n) und hergestellte Schicht erfolgen. Wenn während der Schichtherstellung eine Anpassung der Istwerte an die Sollwerte nicht mehr möglich ist, kann unter Umständen der Beschichtungsprozeß abgebrochen werden.

Um zu kontrollieren, daß $p\infty_i$ nur von der Legierungzusammensetzung und nicht auch durch Änderungen im Partialdruck von zum Beispiel Dotiergasen beeinflußt wird, ist es empfehlenswert, mit Hilfe eines Massenspektrometers die Gaszusammensetzung im Beschichtungsraum zu kontrollieren oder zu regeln.

Im Falle der Kontrolle des Schichtherstellungsprozesses findet kein Vergleich von Ist- und Sollwerten statt. Die Istwerte von $p\infty_i$ werden dann nur aufgezeichnet zum Beispiel auf Papier, Bildschirm oder gespeichert, zum Beispiel auf einer Floppy-Disk oder Hard-Disk. Ohne weitergehende Prüfung der Schichten kann dann entschieden werden, ob die gerade hergestellten Schichten den "Soll-Schichten" gleichen und ob weitere Fertigungsschritte sinnvoll sind oder ob die Schichten als Ausschuß angesehen werden müssen.

Das erfindungsgemäße Verfahren mit konstanter Führungsgröße findet bevorsugt Anwendung bei der Herstellung von elektrischen Widerstandsschichten zum Beispiel Cr-Ni, Cr-Si, Cu-Ni, Cr-Ni-O, Cr-Si-O, von Silizidschichten zum Beispiel als Gatematerial oder Leiterbahnen (Ta-Si, W-Si, Ti-Si, Mo-Si, Pd-Si, usw...) und von Leiterbahnen (Al-Si, Al-Ti-Si, Al-Si-Cu).

Das Verfahren mit variabler Führungsgröße kann bevorzugt angewendet werden zum Beispiel zur Erzeugung einer Passivierungsschicht auf der Schichtoberseite (zum Beispiel kann eine Si-reichere Oberfläche von $TaSi_2$-Schichten die Ausbildung einer $SiO_2$-Passivierungsschicht fördern). Eine andere Anwendung ist die Erzeugung eines besseren Kontaktes oder Haftung zwischen Substrat und Schicht (zum Beispiel verbessert eine chromreiche Anfangsschicht bei Cr/Ni-Schichten die Haftung).

Eine weitere Anwendungsmöglichkeit besteht in der Herstellung von Zwischenschichten, die zum Beispiel als Diffusionsbarrier wirken (zum Beispiel eine Wolframzwischenschicht in einer Aluminium-Schicht) Außerdem ist es möglich, durch speziell dotierte Ausgangsmaterialien gezielt Doterungsprofile (mit zum Beispiel Bor, Phosphor, Arsen) in Silizium- oder Metallsilizidschichten einzubringen, so daß man zeitaufwendige Diffusionsprozesse bei hohen Temperaturen umgehen kann.

Die beschriebene Kontrolle und Regelung des Schichtherstellungsprozesses hat den großen wirtschaftlichen Vorteil, daß eine gezielte in höchstem Maße reproduzierbare Fertigung von dünnen Schichten möglich ist, wodurch erhebliche Kosten eingespart werden können.

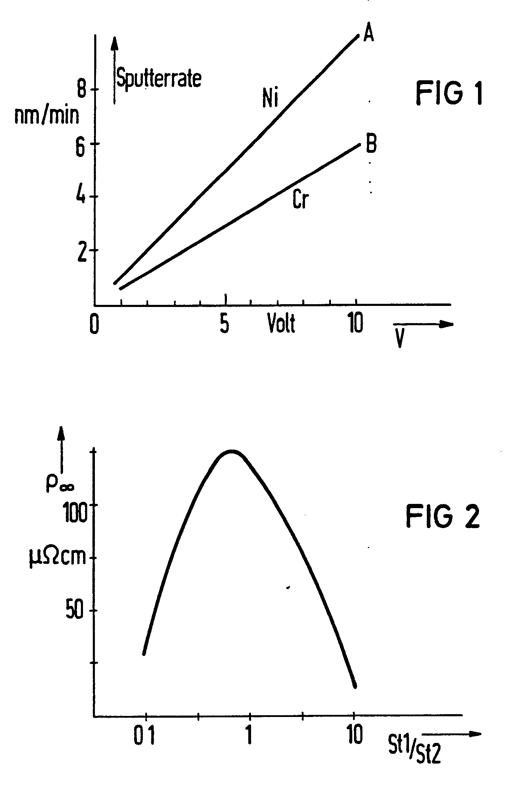

Die Erfindung wird anhand von vier Ausführungsbeispielen und der Figuren 1 und 2 noch näher erläutert. Dabei zeigt

die Figur 1 die Abhängigkeit der Sputterrate von der Steuerspannung (Targetleistung) für Nickel (A) bzw. Chrom (B) und

# EP 0 152 577 B1

die Figur 2 den spezifischen elektrischen Widerstand in Abhängigkeit von der Zusammensetzung für das System Chrom-Nickel.

Die elektrischen Widerstandsmessungen werden während der Schichtherstellung mit einer in-situ-Widerstandsmeßvorrichtung durchgeführt, wie sie in Siemens Forsch.- und Ent.-Ber. Bd. 11 (1982), Seiten 322 bis 326, beschrieben ist. Die Schichtherstellung erfolgt in einer Sputteranlage vom Typ Perkin Elmer 4400 durch Sputtern von einem oder von 2 Targets. Während der Beschichtung werden das Referenzsubstrat sowie die übrigen Substrate unter dem Target hindurchgedreht. Bei dieser Art der Schichtherstellung wird die aktuelle Schichtdicke aus der Anzahl der Umdrehungen und der pro Umdrehung aufgebrachten Lagendicke (oder beim Cosputtern der Gesamtlagendicke=2 Teillagen), die in einem Vorversuch bestimmt wird, errechnet. Der elektrische Schichtwiderstand wird jeweils einmal pro Palettenumdrehung nach (oder vor) dem Aufbringen sämtlicher Teillagen gemessen und drahtlos aus der Sputteranlage an einen Empfänger übertragen und von dort von einem Rechner (MINC 23 von Digital Equipment) übernommen. Der Rechner berechnet die Istwerte der Regelgröße—wie beschrieben—entweder aus den Produkten $(\rho d)_i$ und vergleicht die Istwerte mit den Sollwerten. Bei Regelabweichungen legt er die Änderung des Stellgliedes gemäß einer vorgegebenen Antwortfunktion fest, die in einem Vorversuch unter den späteren Herstellbedingungen aufgenommen worden ist als Zusammenhang zwischen der Regelgröße $\rho\infty$ und der Schichtkonzentration (=Ratenverhältnis). Die Steuerung der Beschchtungsrate(n) erfolgt über eine (zwei) 0 bis 10 V Spannung(en), die vom Rechner über einen Digital/Analog Wandler erzeugt wird (werden). Es wird der Fall erprobt, daß jedes der beiden Targets getrennt geregelt wird, und der Fall, daß die beiden Targets über einen Widerstand als Spannungsteiler gekoppelt sind und nur die Spannungsverteilung geregelt wird.

Die Beschichtung wird beendet, sobald ein vorgegebener Flächenwiederstandswert erreicht wird.

Beispiel 1:
Herstellung einer Cr-Ni Widerstandsschicht

| | |
|---|---|
| Sputtertargets: | Cr und Ni |
| Sputtermode: | DC-Cosputtern |
| Sputtergas: | Argon ($10^{-2}$ mbar) |
| Zeit pro Palettenumdrehung: | 6 sec |
| Endwert des Gesamtwiderstandes: | 50 $\Omega/\square$ |
| Sollwert $\rho\infty_i$: konstant: | 125 $\mu\Omega$ cm |
| Steuerspannung des Ni-Targets: | 5 V |

In Vorversuchen wird der Zusammenhang zwischen Targetleistung Ni (Steuerspannung, St1) bzw. Targetleistung Cr (Steuerspannung St2) und der Schichtdicke ermittelt (siehe Figur 1). In einem weiteren Vorversuch wird die Abhängigkeit von $\rho\infty$ von der Zusammensetzung, das heißt dem Verhältnis St1/St2 bestimmt (siehe Figur 2).

Aus den Vorversuchen geht hervor, daß die Schichtdicke praktisch proportional zur Targetleistung (bzw. die Steuerspannung die Targetleistung (bzw. die Steuerspannung die Targetleistung bestimmt) ist. Damit läßt sich die Schichtzusammensetzung—und damit auch $\rho\infty$—durch das Verhältnis der beiden Steuerspannungen charakterisieren.

Bei Vorgabe einer bestimmten Leistung (Steuerspannung 1) am Ni-Target und eines gewünschten $\rho\infty$—Wertes (zum Beispiel 125 $\mu\Omega$ cm) läuft der Beschichtungsprozeß bei proportionaler Regelung folgendermaßen ab:

7

## EP 0 152 577 B1

| Drehzahl: | 1 | 2 | 3 | 4 | : 23 | 24 |
|---|---|---|---|---|---|---|
| Schichtwider-stand [Ω] | 1427 | 687 | 447 | 325... | · 52,5 | 50,28 |
| Gesamtschicht-dicke [nm] | 0,82 | 1,74 | 2,71 | 3,75... | 23,70 | 24,75 |
| spez. elektr. Widerstand [μΩcm] | 117 | 119,6 | 121 | 122,2... | 125 | 125 |
| Istwert: momentaner spez. elektr. Widerstand $\rho\infty_i$ [μΩcm] | | 122 | 124 | 125... | : 125 | 125 |
| Sollwert: $\rho\infty_i$ [μΩcm] | | 125 | 125 | 125... | 125 | 125 |
| Steuerspannung St 1 [V] 5 | | 5 | 5 | 5... | 5 | 5 |
| Steuerspannung St1 [V] 5 | | 6,5 | 8,0 | 9,0... | 9,3 | 9,3 |

Nach der 24ten Lage ist der gewünschte Endwiderstand von 50 Ω erreicht, so daß der Beschichtungsprozeß beendet werden kann.

Beispiel 2:

Werden die Cr-Ni-Widerstandsschichten aufgedampft, dadurch daß Cr und Ni gleichzeitig durch Elektronenstrahlkanonen verdampft wird, so besteht die Möglichkeit, einen ortsfesten Quarzoszillator zur zusätzlichen Schichtdickenmessung zu verwenden. Dies ist beim Aufdampfen notwendig, da man bei diesem Verfahren—im Gegensatz um Aufstäuben—nicht annehmen kann, daß die Abscheiderate immer konstant ist. Aush dem Schichtwiderstand $\rho$ bzw. $\rho\infty_i$ und der Schichtdicke wird dann wie im Beispiels 1 die Leistung zum Beispiel eines Elektronenstrahlverdampfers derart verändert, daß kein Ist-Sollwert-Abweichungen auftreten. Die Substrate sind hier ortsfest.

Beispiel 3:

Die im Beispiel 1 und 2 aufgezeigten Verfahren können auch zur Herstellung von Schichten mit definierten Konzentrationsprofilen in Abhängigkeit von der Schichtdicke verwendet werden. In Al-Schichten, die als Leiterbahnmaterial eingesetzt werden, werden Zwischenschichten aus zum Beispiel Wolfram aufgebracht, um die Stromtragfähigkeit der Leiterbahnen zu erhöhen.

Die Regelung erfolgt in diesem Fall derart, daß die Steuerung 1 für die Al-Quelle zunächst zum Beispiel auf +8V steht und die Steuerspannung 2 für Wolfram auf Null. Nach Erreichen einer gewissen Al-Schichtdicke wird kurzzeitig St 1 auf 0V und St 2 auf zum Beispiel 10V geregelt. Anschließend werden über den Rechner wieder die anfänglichen Werte für St 1 und St 2 eingestellt. Die Herstellung erfolgt durch Sputtern von 2 Targets.

Beispiel 4:

Bei der Herstellung von Silizidschichten (zum Beispiel Tantalsilizid) geht man beim Cosputtern von einem reinen Tantaltarget und einem Silizium-Target aus, das einen geringen Tantalgehalt (zum Beispiel 5 Mol%) besitzt. Da beide Materialien elektrisch gut leiten, kann die Regelung wie in Beispiel 1 erfolgen. Da Legierungstargets höchster Reinheit sehr teuer sind, ist es jedoch vorteilhaft, von den reinen Komponenten Tantal und Silizium auszugehen. Da Silizium elektrisch schlecht leitend ist, erfolgt die Regelung der Schichtzusammensetzung derart, daß über die Steuerspannung St 1 die Gestamtleistung der nan für Tantal und Silizium gemeinsamen Leistungsversorgung konstant gehalten wird und mit der Steuerspannung St 2 die Leistungsaufteilung geregelt wird. Bem HF-Co-sputtern erfolgt die Leistungsaufteilung über einen Regelkondensator, beim DC-Cosputtern über ein Potentiometer. Da die Lagendicken von zum Beispiel 0,5 bis 5 nm Tantal und Silzium bereits während der Herstellung ineinanderdiffundieren kann nach dem jeweiligen Aufbringen einer Doppellage eine Widerstandserniedrigung gemessen werden und somit ein $\rho\infty_i$-Wert errechnet werden. Bei Soll-Istwert Abweichungen wird über die Steuerspannung St 2 die Leistungsaufteilung in der Art verändert, daß zum Beispiel bei zu hohem Tantal-Gehalt in der Schicht, in dem Maße wie die Leistung am Tantal-Target erniedrigt wird, die Leistung am Silizium-Target erhöht wird.

**Patentansprüche**

1. Verfahren zur Kontrolle und Regelung der Legierungszusammensetzung von elektrische leitenden metallischen Schichten, wie sie insbesondere in der Halbleiter- und Dünnschichttechnik verwendet werden, während der Schichtherstellung durch Aufdampfen oder Aufstäuben mit Hulfe elektrischer Widerstandsmessungen, dadurch gekennzeichnet, daß

a) fortlaufend der momentane elektrische Schichtwiderstand $R_i$ und die momentane Schichtdicke $d_i$ gemessen bzw. bestimmt werden,

b) daraus der Istwert der Regelgröße $\rho\infty_i$ ermittelt wird,

c) der Istwert mit dem Sollwert von $\rho\infty_i$ für die Schichtdicke $d_i$ verglichen wird,

d) bei Regelabweichungen (Soll-Istwert-Differenzen) das Ratenverhältnis der Beschichtungsquellen (A und B) als Stellgröße entsprechend verändert wird und

e) bei Erreichen eines bestimmten Endwertes der Beschichtungsvorgang beendet wird.

2. Verfahren nach Anspruch 1, dadurch gekennzeichnet, daß die Regelgröße $\rho\infty_i$ als Steigung einer Geraden durch die Punkte $(d_i, (\rho \cdot d)_i$ und mindestens einem weiteren Punkt $d_j, (\rho \cdot d)_j$ mit $0<j<i$ ermittelt wird, wobei $\rho_i$ der spezifische elektrische Widerstand der Schicht bei der Schichtdicke $d_i$ ist.

3. Verfahren nach Anspruch 1, dadurch gekennzeichnet, daß für die Regelgröße $\rho\infty_i$ der Schichtwiderstand R, der Flächenwiderstand $R_F$ oder der spezifische elektrische Widerstand verwendet werden.

4. Verfahren nach einem der Ansprüche 1 bis 3, dadurch gekennzeichnet, daß die Schichtdicke $d_i$ aus der Beschichtungszeit und der Beschichtungsrate errechnet wird.

5. Verfahren nach einem der Ansprüche 1 bis 4, dadurch gekennzeichnet, daß als Wert für die Beendigung des Beschichtungsprozesses die Schichtdicke, der gemessene Schichtwiderstand, der spezifische elektrische Widerstand, der Flächenwiderstand und/oder die Beschichtungszeit verwendet werden.

6. Verfahren nach einem der Ansprüche 1 bis 5, dadurch gekennzeichnet, daß in Abänderung des Verfahrens nach Anspruch 1 zur Kontrolle der Schichtzusammensetzung keine Regelung nach Verfahrensschritt c) und d) durchgeführt wird.

7. Verfahren nach einem der Ansprüche 1 bis 6, dadurch gekennzeichnet, daß die Messung von $R_i$ nach einer Änderung der Schichtdicke zwischen 0,1 und 50 nm, vorzugsweise nach einer Änderung im Bereich zwischen 1 bis 20 nm, erfolgt.

8. Verfahren nach einem der Ansprüche 1 bis 7, dadurch gekennzeichnet, daß die Änderung der Stellgröße gemäß der Regelcharakteristik eines Proportional-Reglers, eines Integral-Reglers, eines Proportional-Integral-Reglers, eines Proportional-Differential- oder Proportional-Integral-Differential-Reglers durchgeführt wird.

9. Verfahren nach einem der Ansprüche 1 bis 8, dadurch gekennzeichnet, daß die Meßwerte über einen Prozeßrechner erfaßt und berechnet werden.

10. Verfahren nach einem der Ansprüche 1 bis 9, dadurch gekennzeichnet, daß die Schicht lagenweise aufgebracht wird und die Schichtdicke aus der Einzellendicke und der Anzahl der Lagen errechnet wird.

11. Verfahren nach Anspruch 10, dadurch gekennzeichnet, daß das Wertepaar $d_i$, $R_i$ nach dem Aufbringen von jeweils einer vollständigen Teillage gemessen wird.

12. Verfahren nach einem der Ansprüche 1 bis 9, dadurch gekennzeichnet, daß der Sollwert von $\rho\infty_i$ während der Schichtherstellung konstant ist.

13. Verfahren nach einem der Ansprüche 1 bis 9, dadurch gekennzeichnet, daß sich der Sollwert von $\rho\infty_i$ in Abhängigkeit von der Schichtdicke ändert.

14. Anwendung des Verfahrens nach einem der Ansprüche 1 bis 13, zur Herstellung elektrischen Widerstandsschichten wie Chrom Nickel-, Chrom-Silizium-, Kupfer-Nickel-, Schichten mit und ohne Sauerstoffdotierung, zur Herstellung von Gateelektroden und Leiterbahnen für integrierte Schaltungen wie Silizide hochschmelzender Metalle, wie Tantalsilizid, Molybdänsilizid, Titansilizid und Wolframsilizid und Aluminium-Silizium-Legierungen mit Kupfer und Titananteilen.

15. Anwendung des Verfahrens nach einem der Ansprüche 1 bis 13, auf die Herstellung von Schichten mit einer über dem Schichtquerschnitt variablen Legierungszusammensetzung.

**Revendications**

1. Procédé pour commander et régler la composition de l'alliage de couches métalliques électriquement conductrices, du type utilisées notamment dans la technique des semiconducteurs et dans la technique à couches minces, pendant la fabrication des couches par dépôt par évaporation ou pulvérisation à l'aide de mesures électriques de résistance, caractérisé par le fait que

a) on mesure ou on détermine en permanence la résistance de couche électrique instantanée $R_i$ et l'épaisseur de couche instantanée $(d_i)$,

b) on détermine, à partir de là, la valeur réelle de la grandeur de réglage $\rho\infty_i$.

c) on compare la valeur réelle à la valeur de consigne de $\varphi\infty_i$ pour l'épaisseur de couche $d_i$,

d) dans le cas d'écarts de réglage (différences valeur de consigne-valeur réelle), on modifie de façon correspondante le rapport des vitesses de dépôt des couches de revêtement (A et B) en tant que grandeur de réglage, et

e) on arrête l'opération de dépôt lorsqu'une valeur finale déterminée est atteinte.

2. Procédé suivant la revendication 1, caractérisé par le fait qu'on détermine la grandeur de réglage $\rho\infty_i$ sous la forme d'une pente d'une droite passant par les points $d_i$, $(\rho \cdot d)_i$ et au moins un autre point $(d_j)$, $(\rho \cdot d)_j$ avec $o<i<j$, $\rho_i$ étant la résistance électrique spécifique de la couche pour l'épaisseur de couche $d_i$.

3. Procédé suivant la revendication 1, caractérisé par le fait qu'on utilise, pour la grandeur de réglage $(\rho\infty_i)$, la résistance de couche R, la résistance superficielle $R_F$ ou la résistance électrique spécifique.

4. Procédé suivant l'une des revendications 1 à 3, caractérisé par le fait qu'on calcule l'épaisseur de couche $d_i$ à partir de la durée et de la vitesse de dépôt de la couche.

5. Procédé suivant l'une des revendications 1 à 4, caractérisé par le fait qu'on utilise, comme valeur pour arrêter l'opération de dépôt, l'épaisseur de couche, la résistance de couche mesurée, la résistance électrique spécifique, la résistance superficielle et/ou la durée de dépôt.

6. Procédé suivant une des revendications 1 à 5, caractérisé par le fait qu'à titre de variante du procédé selon la revendication 1 pour commander la composition de la couche, on ne réalise pas la régulation conformément aux étapes opératoires c) et d).

7. Procédé suivant l'une des revendications 1 à 6, caractérisé par le fait que la mesure de $R_i$ est réalisée après une modification de l'épaisseur de couche comprise entre 0,1 et 5 nm, de préférence après une modification dans la gamme allant de 1 à 20 mm.

8. Procédé suivant l'une des revendications 1 à 7, caractérisé par le fait qu'on exécute la modification de la grandeur de réglage conformément à la caractéristique de réglage d'un régulateur à action proportionnelle, d'un régulateur à action intégrale, d'un régulateur à action proportionelle et intégrale, d'un régulateur à action proportionnelle et différentielle et d'un régulateur à action proportionelle, intégrale et différentielle.

9. Procédé suivant l'une des revendications 1 à 8, caractérisé par le fait que les valeurs de mesure sont détectées et calculées par l'intermédiaire d'un calculateur de processus.

10. Procédé suivant l'une des revendications 1 à 9, caractérisé par le fait qu'on dépose la couche sous la forme de strates et qu'on calcule l'épaisseur de couche sur la base de l'épaisseur des strates individuelles et du nombre des strates.

11. Procédé suivant la revendication 10, caractérisé par le fait qu'on mesure le couple de valeurs $d_i$, $R_i$ après le dépôt respectivement d'une strate partielle complète.

12. Procédé suivant l'une des revendications 1 à 9, caractérisé par le fait que la valeur de consigne de $\rho\infty_i$ est constante pendant la fabrication de la couche.

13. Procédé suivant l'une des revendications 1 à 9, caractérisé par le fait que la valeur de consigne de $\rho\infty_i$ varie en fonction de l'épaisseur de la couche.

14. Application du procédé suivant l'une des revendications 1 à 13, pour la fabrication de couches résistives électriques, comme par exemple des couches de chrome-nickel, de chrome-silicium, de cuivre-nickel, avec et sans dopage par de l'oxygène, pour fabriquer des électrodes de grille et des voies conductrices pour des circuits intégrés comme par exemple des siliciures de métaux à point de fusion élevé, tel que le siliciure de tantale, le siliciure de molybdène, le siliciure de titane et le siliciure de tungstène et des alliages d'aluminium-silicium contenant des pourcentages de cuivre et de titane.

15. Application du procédé suivant l'une des revendications 1 à 13, pour la fabrication de couches possédant une composition d'alliage variable sur la section transversale de la couche.

## Claims

1. Process for the control and the regulation of the alloy composition of electrically conducting metallic layers, such as are employed, in particular, in semi-conductor and thin-film technology, during the layer production by vapor deposition or sputtering with the aid of electrical resistance measurements, characterized in that

a) the instantaneous electrical layer resistance $R_i$ and the instantaneous layer thickness $d_i$ are measured or determined continuously,

b) the actual value of the controlled variable, $\rho\infty_i$ is established therefrom,

c) the actual value is compared with the desired value of $\rho\infty_i$ for the layer thickness $d_i$,

d) in the case of system deviations (differences between desired value and actual value), the ratio of the rates of the coating sources (A and B) is varied correspondingly as manipulated variable, and

e) when a specified final value is reached the coating process is terminated.

2. Process according to Claim 1, characterized in that the controlled variable $\rho\infty_i$ is established as the gradient of a straight line through the points $d_i$ $(\rho \cdot d)_i$ and at least one further point $d_j$, $(\rho \cdot d)_j$, where $0<j<i$, $\rho_i$ being the specific electrical resistance of the layer given the layer thickness $d_i$.

3. Process according to Claim 1, characterized in that the layer resistance R, the surface resistance $R_F$ or the specific electrical resistance are employed for the controlled variable $\rho\infty_i$.

4. Process according to one of Claims 1 to 3, characterized in that the layer thickness $d_i$ is calculated from the coating time and the coating rate.

5. Process according to one of Claims 1 to 4, characterized in that the layer thickness, the measured layer resistance, the specific electrical resistance, the surface resistance and/or the coating time are employed as value for the termination of the coating process.

6. Process according to one of Claims 1 to 5, characterized in that as a modification of the process according to Claim 1, no regulation is carried out according to the process steps c) and d) in order to control the layer composition.

7. Process according to one of Claims 1 to 6, characterized in that the measurement of $R_i$ takes place after a change in the layer thickness between 0.1 and 50 nm, preferably after a change in the range of between 1 to 20 nm.

8. Process according to one of Claims 1 to 7, characterized in that the change in the manipulated variable is carried out in accordance with the regulation characteristic of a proportional controller, an integral controller, a proportional-plus-integral controller, a proportional-plus-derivative controller or a proportional-plus-integral-plus-derivative controller.

9. Process according to one of Claims 1 to 8, characterized in that the measured values are acquired and computed by a process computer.

10. Process according to one of Claims 1 to 9, characterized in that the layer is applied in coats, and the layer thickness is calculated from the individual coat thickness and the number of the coats.

11. Process according to Claim 10, characterized in that the pair of values $d_i$, $R_i$ are measured after the application of a complete component coat in each case.

12. Process according to one of Claims 1 to 9, characterized in that the desired value of $p\infty_i$ is constant during the layer production.

13. Process according to one of Claims 1 to 9, characterized in that the desired value of $p\infty_i$ varies as a function of the layer thickness.

14. Application of the process according to one of the Claims 1 to 13 to produce electrical resistive layers such as chromium/nickel, chromium/silicon, copper/nickel layers with and without oxygen doping, to produce gate electrodes and conductor tracks, for integrated circuits such as silicides of high-melting metals, such as tantalum silicide, molybdenum silicide, tantanium silicide and tungsten silicide and aluminium/silicon alloys with copper and titanium fractions.

15. Application of the process according to one of Claims 1 to 13 to the production of layers with an alloy composition which is variable over the layer cross-section.

FIG 1

FIG 2